# EUROPÄISCHE PATENTANMELDUNG

(11) **EP 0 937 530 A1**
(43) Veröffentlichungstag der Anmeldung: **25.08.1999**
(21) Anmeldenummer: 98810427.9
(22) Anmeldetag: 11.05.1998
(51) Int. Cl.: B23K 20/00, H01L 21/603

(54) **Verfahren zum Herstellen von Drahtverbindungen an Halbleiterchips**

(30) Priorität: 19.02.1998 CH 39298
(71) Anmelder: ESEC Management SA, 6330 Cham (CH); ESEC SA, CH-6330 Cham/Steinhausen (CH)
(72) Erfinder: Egger, Hans, 5643 Sins (CH); Von Flüe, Daniel, 6330 Cham (CH); Seidel, Marit, 6314 Unterägeri (CH)

(57) **Zusammenfassung**

Beim Herstellen von Drahtverbindungen (wire bonding), die von einem Halbleiterchip ausgehen und auf einem Substrat (2b) enden, soll die den Draht (3) führende Kapillare (12) auf einem Endabschnitt (s3) ihrer Bahn in bestimmter, programmierter Weise bewegt werden, um beim Kontaktieren des Drahtes mit dem Substrat Rückwirkungen auf die Geometrie der Drahtbrücke möglichst auszuschliessen und einwandfreie Kontaktverbindungen zu erzeugen. Der Endabschnitt (s3), in welchem die Kapillare (12) gebremst wird, beginnt auf vorbestimmter Höhe (H) und endet auf dem Substrat beim zweiten Anschlusspunkt (5). Der abwärts gerichteten Bewegung (vv) der Kapillare wird eine horizontale Bewegung (vh) überlagert, die vom bereits bestehenden Anschluss des Drahtes (3) auf dem Chip weg gerichtet ist und die im Verhältnis zur Abwärtsbewegung (vv) stetig abnimmt.

## Beschreibung

Die Erfindung betrifft ein Verfahren zur Herstellung von Drahtverbindungen zwischen einem ersten, auf einem Halbleiterchip befindlichen Anschlusspunkt und einem zweiten Anschlusspunkt auf einem Substrat. Mittels solcher Drahtverbindungen werden bei der Halbleitermontage die elektrischen Verbindungen zu der auf dem Chip befindlichen integrierten Schaltung hergestellt. Der zweite Anschlusspunkt der Verbindung kann sich typischerweise auf einem metallischen sogenannten "lead frame" befinden oder auf einem anderen Systemträger, z.B. einer gedruckten Schaltung mit Kunststoff-, Keramik- oder sogenanntem "ball grid array"-Substrat, aber auch ein weiterer Halbleiterchip kann den zweiten Anschlusspunkt aufnehmen, wie im Falle von Anordnungen mit mehreren Chips auf demselben Träger ("multi-chip devices").

Gemäss an sich bekannten Verfahren zur Herstellung solcher Drahtverbindungen läuft ein Draht durch eine mittels programmierbarer Antriebsvorrichtung horizontal und vertikal beweglich geführte Kapillare hindurch, die sowohl zum Befestigen des Drahtes an beiden Anschlusspunkten als auch zur Drahtführung zwischen den Anschlusspunkten dient. Jeweils nach Befestigung des Drahtes am ersten Anschlusspunkt wird die Kapillare von der genannten Antriebsvorrichtung zum zweiten Anschlusspunkt hin auf einer vorbestimmten Bahn geführt, auf der die benötigte Drahtlänge durchgezogen und der Draht zu einer Brücke geformt wird (z.B. EP-A 0 792 716).

An die Geometrie bzw. Masshaltigkeit und die mechanische Stabilität solcher Drahtbrücken werden hohe Anforderungen gestellt; insbesondere soll im allgemeinen die Höhe der Drahtbögen über der Chipoberfläche und dem Substrat möglichst genau definiert sein, und natürlich darf keine Kantenberührung am Chip auftreten. Oft liegen zahlreiche vom Chip ausgehende Drahtbrücken eng nebeneinander ("fine pitch"), wobei jeglicher Kontakt zwischen benachbarten Drähten vermieden werden muss.

Eine kritische Phase besteht jeweils am Ende der Kapillaren-Bewegung, wenn die Kapillare sich von oben dem Substrat nähert, dessen Höhenlage im allgemeinen von der Chipoberfläche verschieden ist und gewisse Streuungen aufweist. Es ist erforderlich, die hohe Vertikalgeschwindigkeit der Kapillare bei der Annäherung zu reduzieren. Auch ist es bekannt, das Auftreffen der Kapillare auf dem Substrat mittels eines Kraftsensors festzustellen, um die Bewegung ganz zu stoppen und die Kontaktierung des Drahtes am zweiten Anschlusspunkt einzuleiten. Der Draht tritt jedoch unten an der Kapillare zunächst in einem (kleineren oder grösseren) Bogen aus, dessen Scheitel zuerst das Substrat berührt. In der Folge wird der Bogen flachgedrückt und der Draht an der Kapillare scharf geknickt, worauf schliesslich beim Kontaktieren der Drahtquerschnitt zwischen Kapillare und Substrat verformt wird. Es besteht dabei die Gefahr, dass beim "Stauchen" des erwähnten Drahtbogens die vorgeformte Drahtbrücke zwischen der Kapillare und dem ersten Anschlusspunkt unzulässig deformiert bzw. in der Höhe und/oder seitlich ausgebogen wird. Indessen kann der Draht auch teilweise zurück in die Kapillare hinein gestossen werden, d.h. die Situation ist insgesamt schwierig zu beherrschen.

Mit der vorliegenden Erfindung sollen die erwähnten Schwierigkeiten behoben werden, damit in der Serienfertigung Drahtbrücken in der geforderten, programmierten Gestalt mit hoher Formkonstanz und Stabilität erzielt werden.

Diese Aufgabe wird erfindungsgemäss dadurch gelöst, dass auf einem auf vorbestimmter Höhe beginnenden Endabschnitt der programmierten Kapillarenbahn, in welchem die Kapillare den Draht an das Substrat heranführt, der abwärts gerichteten Bewegung der Kapillare eine variable horizontale Bewegung überlagert wird, die vom ersten Anschlusspunkt weg gerichtet ist und im Verhältnis zur Abwärtsbewegung stetig abnimmt.

Damit wird insbesondere erreicht, dass mit hoher Regelmässigkeit ausreichend gestraffte Drahtbrücken gebildet werden, die weder seitwärts noch in der Höhe ausgebogen sind oder zum Ausbiegen neigen. Als weiterer Vorteil konnte ein günstiger Einfluss auf die Querschnittverformung des Drahtes am zweiten Anschlusspunkt und damit auf die mechanische Festigkeit der Kontaktverbindung zum Substrat festgestellt werden.

Die Erfindung wird nachstehend anhand von Ausführungsbeispielen im Zusammenhang mit der Zeichnung näher erläutert.
- Fig. 1: ist die vereinfachte Draufsicht einer an sich bekannten Anordnung und Vorrichtung zur Durchführung des Verfahrens;
- Fig. 2: zeigt einen Teil der Anordnung nach Fig. 1 von der Seite und stark vergrössert;
- Fig. 3, 4 und 5: zeigen, in nochmals grösserem Massstab, die Annäherung der Kapillare an den zweiten Anschlusspunkt in drei aufeinanderfolgenden Phasen;
- Fig. 6: ist die Draufsicht auf den zweiten Anschlusspunkt entsprechend der Fig. 5 (noch etwas grösser gezeichnet), mit dem verformten, befestigten Drahtende; und
- Fig. 7: veranschaulicht eine Variante des Bahnverlaufs im Bereich des Übergangs zum Endabschnitt

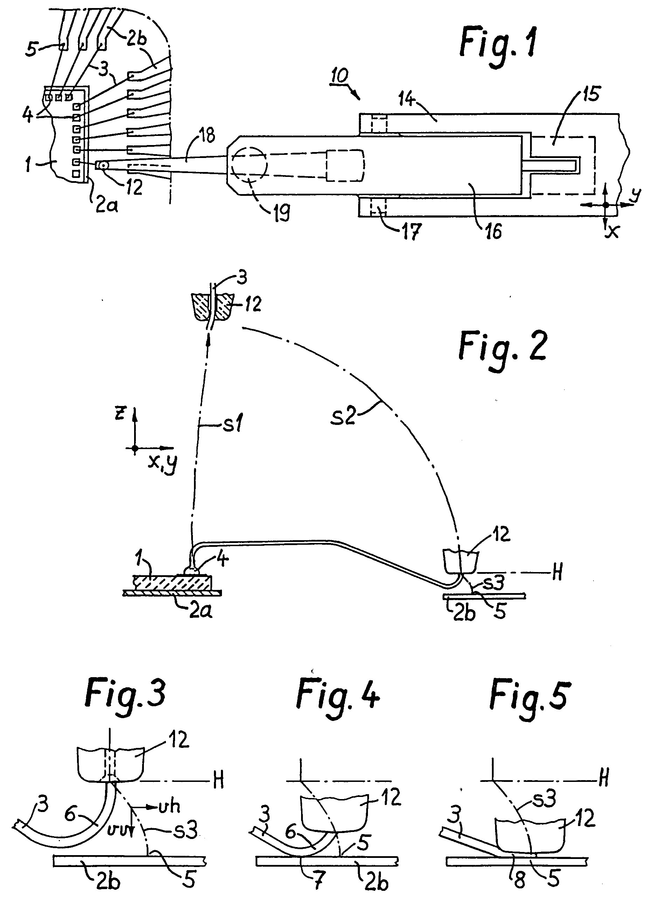

In den Figuren 1 und 2 ist eine generelle Anordnung und eine Vorrichtung, mit der das erfindungsgemässe Verfahren durchgeführt wird, schematisch veranschaulicht. Als Werkstück ist links in Fig. 1 ausschnittweise ein Halbleiterchip 1, der auf einem Systemträger montiert ist, dargestellt. Der Systemträger, z.B. ein sogenannter Leadframe aus gestanztem oder geätztem Kupferblech, weist im wesentlichen die den Chip 1 tragende Insel 2a und ringsum angeordnete Kontaktfinger 2b auf.

Bei dem als "wire bonding" bezeichneten Verfahren werden geformte Drahtverbindungen 3 zwischen ersten, auf der Chipoberfläche befindlichen Anschlusspunkten 4 und zweiten Anschlusspunkten 5 auf den Kontaktfingern 2b hergestellt. Die Verbindungen 3 werden aus einem feinen Draht gebildet, der von oben durch eine horizontal und vertikal bewegliche Kapillare 12 läuft (Fig. 2). Die Kapillare 12 dient einerseits zum Befestigen (Kontaktieren) des Drahtes an den Punkten 4 und 5 und andererseits zur Führung des Drahtes zwischen diesen Punkten.

Die Kapillare 12 ist Bestandteil einer an sich bekannten, Mikroprozessor-gesteuerten Vorrichtung 10, die die erforderlichen Bewegungszyklen durchführt. Ein Schlitten 14 der Vorrichtung 10 führt Horizontalbewegungen aus (x- und y-Richtungen, Fig.1), angetrieben in bekannter, nicht näher dargestellter Weise z.B. mittels Linearmotor. Der Schlitten 14 trägt beim dargestellten Beispiel eine Wippe 16, die zusammen mit einem auf ihr gelagerten Horn 18 um eine horizontale Achse 17 schwenkbar ist (bekannt sind auch vertikal gerichtete Linearführungen für das Horn). Als Schwenkantrieb dient ein auf dem Schlitten 14 befindlicher (Linear-)Motor 15, der die Vertikalbewegungen der Kapillare 12 bewirkt (z-Richtung, Fig. 2). Ueber das Horn 18 wird auch die jeweils für die Kontaktierung in den Punkten 4 und 5 erforderliche Ultraschall-Energie auf die am Ende des Horns eingespannte Kapillare 12 übertragen. Die dabei auf die Unterlage (Chip bzw. Substrat) ausgeübte Vertikalkraft wird mittels eines Kraftsensors 19 gemessen. Ueber der Kapillare 12 ist normalerweise eine steuerbare Drahtklammer (nicht dargestellt) angeordnet, mit der der Drahtdurchlauf gestoppt oder freigegeben werden kann.

An einem bestimmten Werkstück ist jeweils die Lage aller Kontaktierungspunkte 4 und 5 bekannt, und die generelle Gestalt der zu erzeugenden Drahtbrücken 3 (insbesondere auch deren Höhe über dem Chip 1) wird vorgegeben. Daraus ergeben sich die Richtungen der einzelnen Drahtbrücken (x- und y-Komponenten, Fig. 1) und die benötigten Drahtlängen als Basisdaten für die Programmierung der Bewegungszyklen. Jeweils ausgehend von einem Punkt 4 auf dem Chip 1, an dem der Draht zuerst befestigt wird, folgt die Kapillare 12 einer vorbestimmten Bahn zum zweiten Punkt 5, wobei hauptsächlich zwei Bewegungsphasen bzw. Bahnabschnitte zu unterscheiden sind (Fig. 2): Die erste Bewegungsphase s1 führt im wesentlichen vom Chip 1 vertikal nach oben, um die erforderliche Drahtlänge durch die Kapillare 12 zu ziehen, und die zweite Phase s2 führt in einem Bogen abwärts zum Kontaktfinger 2b bzw. zum zweiten Anschlusspunkt 5 hin. Je nach verlangter Geometrie der Drahtbrücke erfolgt während der ersten Phase s1 eine Vorformung des Drahtes, die auch vorübergehende Horizontalbewegungen der Kapillare bedingt. Die in Fig. 2 als Beispiel dargestellte, beinahe fertige Drahtbrücke 3 weist z.B. einen Knick 3a auf, der in an sich bekannter Weise durch Vorformung während der ersten Bewegungsphase s1 erzeugt worden ist.

Auf vorbestimmter, programmierter Höhe H (bezogen auf die Sollhöhe des Kontaktfingers) beginnt ein Endabschnitt s3 der Kapillarenbahn, in welchem die Kapillare 12 mit dem austretenden Draht 3 von oben an den Punkt 5 auf dem Substrat (Kontaktfinger 2b) herangeführt wird. Die Höhenlage des Kontaktfingers ist einer gewissen Streuung unterworfen und zunächst nicht genau bekannt; für die Zwecke der Programmierung wird ein bestimmter Sollwert der Kontaktfinger-Oberfläche angenommen. Die Höhe H ist so bestimmt, dass der Drahtbogen unter der Kapillare den Kontaktfinger 2b jedenfalls noch nicht berührt. Diese Situation nach Fig. 2 ist ausschnittweise in Fig. 3 im grösseren Massstab dargestellt, und der weitere Bewegungsverlauf der Kapillare 12 auf dem Endabschnitt s3 geht aus den Figuren 4 und 5 hervor.

Wenn sich die Unterseite der Kapillare 12 gemäss Fig. 3 auf der Höhe H befindet, tritt der Draht in einem Bogen 6 aus, der beim Herunterfahren der Kapillare entlang dem bogenförmigen Bahnabschnitt s2 entstanden ist. Der Endabschnitt s3 der Kapillarenbahn ist nun in besonderer Weise programmiert, hauptsächlich zum Zweck, unerwünschte Auswirkungen des Drahtbogens 6 auf die Gestalt der Drahtbrücke und auf die Kontaktierung am Substrat zu verhindern. Wie in Fig. 3 dargestellt, ist der von der Höhe H ausgehenden Abwärtsbewegung vv der Kapillare eine variable horizontale Bewegung vh überlagert. Diese horizontale Bewegungskomponente vh ist vom ersten Anschlusspunkt 4 (Fig. 2) weg gerichtet, und sie nimmt im Verhältnis zur Abwärtsbewegung vv stetig ab. Im Ergebnis verläuft also der Abschnitt s3 bogenförmig, zu Beginn zunächst schräg zum Substrat (mit einer Tangente von z.B. etwa 45°), dann immer steiler, um schliesslich etwa vertikal, jedenfalls unter einem steilen Winkel im Punkt 5 auf dem Substrat zu enden. (Selbstverständlich ist bei der Programmierung des Endpunktes des Bahnabschnittes s2 auf der Höhe H der Betrag der horizontalen Bewegung vh im Abschnitt s3 zu berücksichtigen, damit die Bahn an der vorgeschriebenen Stelle des Punktes 5 endet).

Ausgehend von der Lage nach Fig. 3 gelangt die Kapillare 12 auf dem Abschnitt s3 in eine in Fig. 4 dargestellte Zwischenstellung, nachdem der Scheitel des Drahtbogens 6 den Kontaktfinger 2b in einem Punkt 7 berührt hat. Infolge des bis dahin zurückgelegten vertikalen und horizontalen Weges der Kapillare 12 und ihrer nun etwas grösseren Entfernung vom Punkt 4 ist - bei gespannter Drahtbrücke - der Draht etwa wie dargestellt beim Austritt aus der Kapillare etwas geknickt und der Bogen 6 teilweise verflacht worden. Der weiteren Abwärtsbewegung der Kapillare ist, wie aus Fig. 4 erkennbar, nur noch eine verminderte Horizontalbewegung vh überlagert. Angenähert oder idealerweise handelt es sich bei der Kapillarenbewegung entlang dem bogenförmigen Bahnabschnitt s3 um ein "Abrollen" des kurzen Drahtstückes zwischen der Kapillare und dem Punkt 7, wobei der Draht an der Kapillare zunehmend schärfer geknickt, aber weder in die Kapillare hinein noch gegen die Drahtbrücke hin gestossen wird.

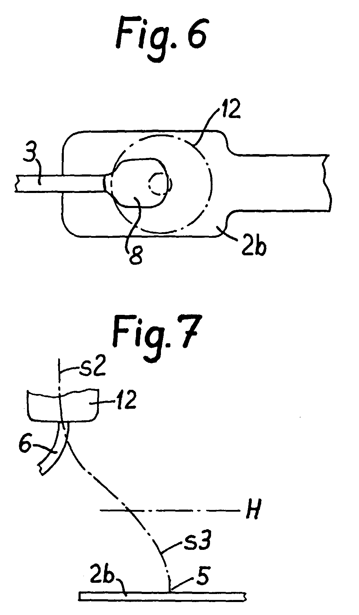

Bei weiterer Abwärtsbewegung und - im Verhältnis zu dieser - annähernd oder ganz verschwindender Horizontalbewegung trifft die Kapillare (bzw. der an ihrer Stirnseite bereits flach anliegende Draht) schliesslich unter steilem Winkel im Bereich des Punktes 5 auf das Substrat. Dabei steigt die an der Kapillare wirkende, nach oben gerichtete Kraft markant an, was mittels Kraftsensor 19 (Fig. 1) festgestellt wird. Für die Steuerung der Vorrichtung 10 (Fig. 1) bedeutet dies die Beendigung der programmierten Bahnbewegungen auf der nun festgestellten, effektiven Höhenlage des Substrats und der Kapillare. In an sich bekannter Weise wird anschliessend das Drahtende unter dosierter Krafteinwirkung seitens des Motors 15 verformt, mittels Ultraschallenergie mit dem Substrat verschweisst und schliesslich abgetrennt. Der Endzustand mit der von der Kapillare in die Breite verformten, kontaktierten Drahtpartie 8 geht aus den Figuren 5 und 6 hervor.

Mit dem beschriebenen Bewegungsablauf im Bahnabschnit s3 können in vorteilhafter Weise regelmässig geformte Drahtbrücken erzielt werden, die straff gespannt sind, also weder durchhängen noch ausgebogen sind oder zum Ausknicken neigen. Das "Ablegen" der Drahtbrücken kann gegebenenfalls durch koordinierte Steuerung der oben erwähnten (nicht dargestellten) Drahtklammer oberhalb der Kapillare unterstützt werden.

Im übrigen kann, wie sich gezeigt hat, ein Bewegungsablauf der oben beschriebenen Art auch günstige Auswirkungen bei der Kontaktierung am zweiten Anschlusspunkt 5 haben. Das erwähnte Anfahren des Substrats unter steilem Winkel in der Grössenordnung von 90° bedeutet, dass das Flachpressen des Drahtendes 8 wie auch dessen Verschweissen auf dem Anschlusspunkt 5 unter der Stirnseite der Kapillare ohne Querverschiebung der Kapillare stattfinden - im Gegensatz etwa zu einer schräg verlaufenden Annäherung der Kapillare, deren damit einhergehende Querbewegung beim Pressen und Schweissen ein keilförmiges Ausziehen und Ausdünnen und die unvollkommene Verschweissung des Drahtendes bewirken kann. Das Formen und Schweissen des Drahtendes 8 vollständig unter der Kapillaren-Stirnseite gemäss Fig. 5 und 6 bedeutet dagegen, dass die Verformung gut kontrollierbar ist und die Schweissverbindung grossflächig bis nahe an den unverformten Draht zustandekommt. Der entsprechende, vorteilhafte Sachverhalt konnte in Versuchsreihen ermittelt werden, bei denen die Kraft, die zum Abreissen der kontaktierten Drähte vom Substrat benötigt wird, gemessen wurde: Schweissverbindungen, die in der im Zusammenhang mit Fig.5 und 6 beschriebenen Weise hergestellt wurden, ergaben signifikant grössere Abreisskräfte als solche, mit deren Herstellung eine Querverschiebung der Kapillare einherging.

Es kann von Vorteil sein, im Gegensatz zum Ausführungsbeispiel nach Fig. 2 bis 5 den Übergang vom Bahnabschnitt s2 zum Endabschnitt s3 ohne Knick zu gestalten; ein Beispiel eines im Bereich der Höhe H entsprechend programmierten Bahnverlaufs ist in Fig. 7 dargestellt. Mit einem solchen "fliessenden" Übergang, bei dem die am Beginn des Abschnittes s3 vorgesehene Horizontalbewegung der Kapillare 12 bereits oberhalb der Höhe H einsetzt, lässt sich eine gewisse Verkürzung der gesamten Zykluszeit erreichen.

## Patentansprüche

1. Verfahren zur Herstellung einer Drahtverbindung zwischen einem ersten, auf einem Halbleiterchip (1) befindlichen Anschlusspunkt (4) und einem zweiten, auf einem Substrat (2) befindlichen Anschlusspunkt (5),
wobei ein Draht (3) durch eine mittels programmierbarer Antriebsvorrichtung (10) horizontal und vertikal beweglich geführte Kapillare (12) hindurchläuft, die sowohl zum Befestigen des Drahtes an beiden Anschlusspunkten (4, 5) als auch zur Drahtführung zwischen diesen dient,
und wobei, nach Befestigung des Drahtes (3) am ersten Anschlusspunkt (4), die Kapillare (12) von der Antriebsvorrichtung (10) zum zweiten Anschlusspunkt (5) hin auf einer vorbestimmten Bahn (s1, s2) geführt wird, auf welcher die benötigte Drahtlänge durchgezogen und der Draht (3) zu einer Brücke geformt wird,
dadurch **gekennzeichnet**,
dass auf einem auf vorbestimmter Höhe (H) beginnenden Endabschnitt (s3) der Bahn, in welchem die Kapillare (12) den Draht (3) an das Substrat (2b) heranführt, der abwärts gerichteten Bewegung (vv) der Kapillare (12) eine variable horizontale Bewegung (vh) überlagert wird, die vom ersten Anschlusspunkt (4) weg gerichtet ist und im Verhältnis zur Abwärtsbewegung (vv) stetig abnimmt.

2. Verfahren nach Anspruch 1, dadurch gekennzeichnet, dass man den Endabschnitt (s3) der Kapillarenbahn mit einer der abwärts gerichteten Bewegung (vv) etwa vergleichbaren horizontalen Bewegung (vh) der Kapillare (12) beginnen lässt.

3. Verfahren nach Anspruch 1 oder 2, dadurch gekennzeichnet, dass man die horizontale Bewegung (vh) gegen das Ende des Endabschnittes (s3) annähernd oder vollständig auf Null reduziert.
